(19) Europäisches Patentamt
European Patent Office
Office européen des brevets

(11) EP 4 492 074 A1

(12) EUROPEAN PATENT APPLICATION
published in accordance with Art. 153(4) EPC

(43) Date of publication:
15.01.2025 Bulletin 2025/03

(51) International Patent Classification (IPC):
$G01R\ 31/392^{(2019.01)}$    $G01R\ 31/367^{(2019.01)}$
$G01R\ 31/382^{(2019.01)}$    $G01R\ 31/385^{(2019.01)}$
$H01M\ 10/48^{(2006.01)}$

(21) Application number: 23766300.0

(52) Cooperative Patent Classification (CPC):
G01R 31/367; G01R 31/382; G01R 31/385;
G01R 31/392; H01M 10/48; Y02E 60/10

(22) Date of filing: 12.01.2023

(86) International application number:
PCT/JP2023/000629

(87) International publication number:
WO 2023/171119 (14.09.2023 Gazette 2023/37)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 09.03.2022 JP 2022036534

(71) Applicant: Hitachi, Ltd.
Tokyo 100-8280 (JP)

(72) Inventors:
• MIYAZAKI, Taizo
Tokyo 100-8280 (JP)
• NAKAO, Ryohhei
Tokyo 100-8280 (JP)
• KAWAJI, Jun
Tokyo 100-8280 (JP)

(74) Representative: Strehl Schübel-Hopf & Partner
Maximilianstrasse 54
80538 München (DE)

(54) **STATE DIAGNOSIS DEVICE AND STATE DIAGNOSIS SYSTEM**

(57) A state diagnosis system (101) can appropriately ascertain the state of a battery. A state diagnosis device (11) comprises a waveform approximation model processing unit (24) that acquires characteristic curve information (D25) for a battery (10) under measurement, a battery state estimation unit (30) that estimates the state of the battery (10) on the basis of the location within the characteristic curve information (D25) of a characteristic point that satisfies a prescribed condition, and a waveform parameter searching unit (44) that selects, and applies to waveform approximation model information (D28), a waveform parameter (D26) that corresponds to the battery (10) under measurement from a database (15) that stores, in association with a plurality of types of batteries (10), a plurality of waveform parameters (D26) for respectively determining the waveform shapes of characteristic curve information (D25) that corresponds to the types.

*FIG. 1*

## Description

Technical Field

The present invention relates to a state diagnosis device and a state diagnosis system.

Background Art

As a background art of the present technical field, an abstract of the following Patent Literature 1 describes "The power supply unit 107 of the degradation determination device 100 receives alternating-current power from the alternating-current power supply 109, converts the alternating-current power into direct-current power, and supplies operating power to itself. The connection unit 108 is connected to the battery to be measured of the assembled battery 600, and the setting unit 102 receives an input of discharge condition information of the battery to be measured from the user. The discharge unit 103 controls discharge of the connected battery to be measured based on the discharge condition information, and measures a terminal voltage of the battery to be measured after the discharge. The calculation unit 105 calculates the residual capacity based on the discharge characteristic information in the battery data storage unit 104, the discharge condition information, and the terminal voltage of the battery to be measured. The display unit 106 displays the residual capacity.".

Citation List

Patent Literature

PTL 1: JP 2006-300561 A

Summary of Invention

Technical Problem

Incidentally, there is a demand for more appropriately grasping the state of the battery in the above-described technology.
The present invention has been made in view of the above circumstances, and an object thereof is to provide a state diagnosis device and a state diagnosis system capable of appropriately grasping a state of a battery.

Solution to Problem

In order to solve the above problem, a state diagnosis device of the present invention includes: a waveform approximation model processing unit that acquires characteristic curve information based on a state quantity of a battery to be measured and waveform approximation model information for deriving the characteristic curve information of the battery from the state quantity; a battery state estimating unit that estimates a state of the battery based on positions of feature points satisfying a predetermined condition in the characteristic curve information; and a waveform parameter searching unit that selects, from a database that stores a plurality of waveform parameters for determining a waveform shape of the characteristic curve information according to each type corresponding to a plurality of types of the batteries, the waveform parameter corresponding to the battery to be measured, and applies the selected waveform parameter to the waveform approximation model information.

Advantageous Effects of Invention

According to the present invention, the state of the battery can be appropriately grasped.

Brief Description of Drawings

[FIG. 1] FIG. 1 is a block diagram of a state diagnosis system according to a first embodiment.
[FIG. 2] FIG. 2 is a diagram showing an example of a change in an OCV curve with respect to a change in an SOC.
[FIG. 3] FIG. 3 is a schematic graph of a charging current, an SOC, and a terminal voltage of a battery over time.
[FIG. 4] FIG. 4 illustrates various OCV curves possibly derived by waveform approximation model information.

[FIG. 5] FIG. 5 is an operation explanatory diagram of an inflection point calculation unit.

[FIG. 6] FIG. 6 is a block diagram of a computer.

[FIG. 7] FIG. 7 is a flowchart of a database creation routine.

[FIG. 8] FIG. 8 is a flowchart (1/2) of a state estimation routine.

[FIG. 9] FIG. 9 is a flowchart (2/2) of the state estimation routine.

[FIG. 10] FIG. 10 is a block diagram of a state diagnosis system according to a second embodiment.

[FIG. 11] FIG. 11 is a block diagram of a state diagnosis system according to a third embodiment.

[FIG. 12] FIG. 12 is a block diagram of a state diagnosis system according to a fourth embodiment.

[FIG. 13] FIG. 13 is a block diagram of a state diagnosis system according to a fifth embodiment.

Description of Embodiments

[Outline of Embodiment]

Embodiments described below relate mainly to a state diagnosis system and a degradation diagnosis system of a battery that performs charging and discharging, and are particularly suitable for performing degradation diagnosis of a wide variety of batteries. Examples of application of these embodiments include an in-vehicle battery management system (BMS) attached to an electric vehicle capable of extending a cruising distance by replacing a battery during in-service parking, a stationary charger, and the like. In order to realize a diagnostic means of an SOH (State of Health) of an on-board battery in a BMS, an embodiment described later is effective.

As an effective means for global environmental conservation, electrification of land, sea, and air vehicles, for example, electric vehicles are expected. Since the electric vehicle stores energy in a battery and travels using the electric power, the electric vehicle has a feature of not discharging environmental load substances during traveling. However, the energy density per unit volume and unit weight of the battery is lower than that of chemical energy such as gasoline and hydrogen, and there is a problem that the cruising distance is shorter than that of an internal combustion engine vehicle. Therefore, charging must be performed frequently, and the charging time is longer than the fuel replenishing time, which deteriorates the convenience of the electric vehicle user.

As a means for solving this problem, a battery replacement service has been studied. The battery replacement service replaces a vehicle battery having a reduced state of charge (SOC) of the battery with a charged battery. As a result, it is possible to substitute the work of a relatively short time of replacement for the charging time which normally takes a long time. When the deterioration has not progressed, the replaced battery is fully charged again and is in a state of waiting for replacement to another electric vehicle. When the battery is deteriorated, the battery is reused as a stationary battery or a disaster auxiliary battery. In a case where the battery is deteriorated to an extent that it cannot be diverted, it is recycled.

In general, since a battery has a large change in performance due to the progress of deterioration, it is preferable to accurately grasp a state of health (SOH) in order to effectively operate the battery. It is considered that the SOH of the battery can be estimated by applying the content of PTL 1 described above. That is, it is considered that the correspondence relationship among the SOC, the open circuit voltage (OCV), and the SOH is stored in advance in a storage means, and the SOH can be diagnosed using the data.

The present embodiment provides a battery state diagnosis system with higher accuracy particularly in an electric vehicle in which a wide variety of batteries are expected to be mounted.

In a conventional electric vehicle, frequent replacement of a battery is not considered, and it is assumed that a state diagnosis of a specific battery is realized. The battery state diagnosis device is mounted on an in-vehicle battery management system (BMS), and a vehicle and a type of a battery correspond to each other on a one-to-one basis. Under such a premise, it is possible to improve the diagnosis accuracy by constructing in detail a mathematical model (hereinafter, referred to as a "physical model") derived from physical knowledge such as the material characteristics and reaction formulas of the battery.

However, if battery replacement is assumed, there may be a case where a battery of a type different from an assumed type may be combined with the vehicle. For example, it is also expected that a battery using a nickel-cobalt-manganese ternary system as a positive electrode material is combined with an in-vehicle BMS assuming iron phosphate as a positive electrode material. In general, although the physical model has very high accuracy, it takes time to construct the physical model, and there is a problem that it is difficult to respond to new batteries developed one after another.

On the other hand, a method in which the measurement result of the battery characteristic is directly applied to the approximate expression and the state diagnosis is performed is considered as an alternative. Since these do not depend on a physical formula, there is an advantage that it is easy to construct a model and it is possible to quickly respond to a new battery, but it is difficult to achieve both accuracy and the advantage.

Therefore, an object of an embodiment to be described later is to provide a state estimation system capable of quickly and easily responding to a new battery and improving accuracy.

In a battery application for an electric vehicle or the like, state estimation such as SOC and life of a battery is performed. Conventionally, these state estimations have been realized based on an electrochemical physical model. However, there is a problem that it takes time to derive the physical model and it takes time for service in of the new battery. In the embodiment described later, there is an effect that the new battery introduction period can be shortened by using the waveform approximation model that directly approximates the characteristic curve of the battery without depending on the physical model. On the other hand, the waveform approximation model is considered to be disadvantageous in terms of accuracy as compared with the physical model. In this regard, the waveform parameters (adjustment factors for determining the waveform) of the waveform approximation model with sufficient accuracy secured are stored in the database, and the waveform parameters are referred as necessary, whereby sufficient accuracy can be obtained.

In addition, determination reference information such as how to determine the approximate waveform obtained by the waveform approximation model can also be given from the database at the same time. As a result, there is an effect that it is possible to flexibly cope with an operation method in which change of a battery frequently occurs, such as a service of replacing a battery instead of charging or replacement of a deteriorated battery at any time. Furthermore, in an embodiment to be described later, the state estimation device includes a waveform parameter searching means (searching unit) that acquires the waveform parameter candidate from the database and selects a suitable waveform parameter using a broad-sense monotonically increasing condition ($f(x1) \leq f(x2)$ when $x1 < x2$).

According to this method, it is possible to cope with a case where the battery cannot be identified and the database cannot be directly used. When the battery cannot be identified, the waveform parameter candidates stored in the database are sequentially checked to finally determine a suitable waveform parameter. It is the broad-sense monotonically increasing condition to determine whether or not the waveform parameter is suitable. The waveform (OCV curve) of the OCV with respect to the SOC is used for the state estimation of the battery, but when the OCV value is x and the SOC value at that time is f (x), a broad-sense monotonically increasing condition ($f(x1) \leq f(x2)$ if $x1 < x2$) is satisfied. By using this characteristic, it is possible to determine a suitable waveform parameter, and as a result, it is possible to provide a suitable waveform parameter even in a case where the battery cannot be identified.

[First Embodiment]

<Configuration of First Embodiment>

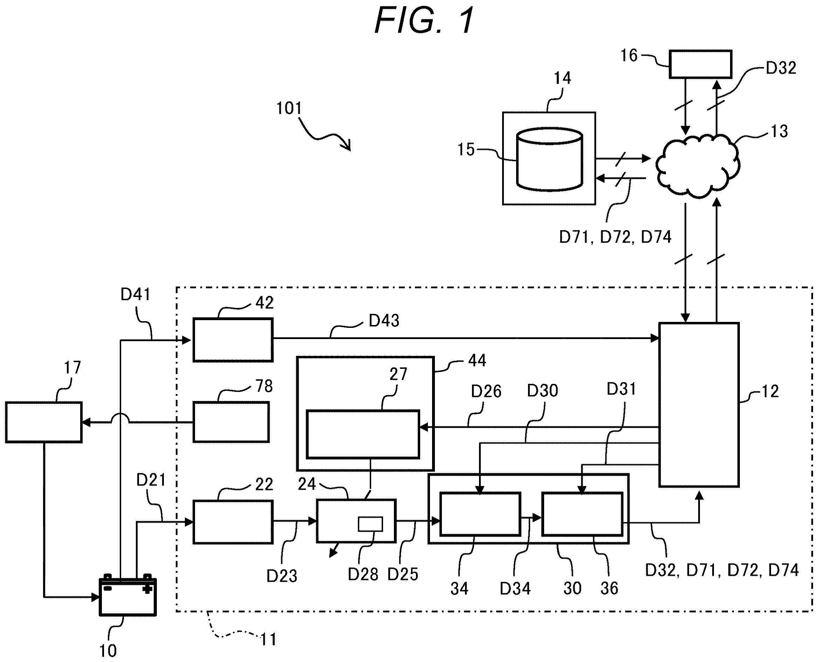

FIG. 1 is a block diagram of a state diagnosis system 101 according to a first embodiment.

The state diagnosis system 101 acquires a state of a battery 10 which is a deterioration diagnosis target, and includes a state diagnosis device 11, a battery information server 14 (server device), a battery operation history storage 16, and a charger 17. The state diagnosis device 11, the battery information server 14, and the battery operation history storage 16 mutually transmit and receive various data via a communication network 13.

The communication network 13 is realized by a computer communication network, a telephone network, or the like. The battery information server 14 includes a database 15 that stores information of the various batteries 10, and provides the information stored in the database 15. The battery operation history storage 16 records a diagnosis result (details will be described later) of the state diagnosis device 11. The information recorded in the battery operation history storage 16 is used for various battery-related services such as replacement notification service of the battery 10 and battery price determination.

The state diagnosis device 11 includes a communication unit 12, a data processing unit 22, a waveform approximation model processing unit 24, a battery state estimating unit 30, an identification information acquiring unit 42, a waveform parameter searching unit 44, and a charging control unit 78. Here, the waveform parameter searching unit 44 includes a battery state diagnosis device 27. The battery state estimating unit 30 includes an inflection point calculating unit 34 and an inflection point position comparing unit 36.

Although not illustrated, the state diagnosis device 11 is preferably mounted on a device such as a battery management system (BMS) charger controller or a vehicle integrated controller, for example. The state diagnosis device 11 can be implemented by software written in a microcontroller, a programmable device such as a PLD or an FPGA, a system on a chip, or the like. The communication unit 12 communicates with the battery information server 14 or the battery operation history storage 16 via the communication network 13.

Various sensors (not illustrated) are attached to the battery 10. Each sensor measures the terminal voltage, the input/output current, and the temperature of the battery 10, and outputs the result as sensor information D21 (state quantity). Note that, regarding the processing in the state diagnosis device 11, the description of the processing corresponding to the temperature may be omitted in order to simplify the description. The data processing unit 22 in the state diagnosis device 11 converts the sensor information D21 into a battery state quantity D23 which is an index or a physical quantity suitable for use in the deterioration state diagnosis as necessary. The battery state quantity D23 includes, for example, discrete values such as an SOC and an OCV of the battery 10.

The waveform approximation model processing unit 24 stores waveform approximation model information D28, thereby processing the discrete battery state quantity D23 and calculating characteristic curve information D25. The waveform approximation model information D28 includes information defining the OCV characteristic with respect to the SOC, and the characteristic curve information D25 includes information of the OCV characteristic curve with respect to the SOC.

The waveform approximation model information D28 may be expressed by a spline curve or a Volterra series. However, it is preferable that the waveform approximation model information D28 be realized by a model that expresses the waveform by an approximate formula without using such a specific physical formula. By not using the physical model, the characteristic curve information D25 of a wide variety of batteries can be obtained with a smaller amount of information and an identification procedure as compared with the case of using the physical model. A specific example of the waveform approximation model information D28 will be described later.

The battery state estimating unit 30 estimates the deterioration state of the battery 10 based on the characteristic curve information D25. The inflection point calculating unit 34 included in the battery state estimating unit 30 receives the inflection point search information D30 from the battery information server 14 via the communication unit 12. Then, the inflection point calculating unit 34 calculates the positions of one or a plurality of inflection points in the characteristic curve information D25 using the inflection point search information D30, and outputs the result as inflection point information D34.

Here, the inflection point search information D30 is information indicating an existence range of the inflection point, that is, an SOC range or the like according to the type of the battery 10. By using the inflection point search information D30, it is possible to easily search for the position of the inflection point at which the degradation of the battery 10 can be effectively determined, that is, the SOC or the like at which the inflection point appears.

For example, in an iron phosphate-based lithium-ion battery containing lithium in a positive electrode and graphite in a negative electrode, the following events A1, A2, and A3 tend to appear.

- A1: One inflection point (referred to as a low SOC-side inflection point) appears in a region where the SOC is less than 50%.
- A2: Another inflection point (referred to as a high SOC-side inflection point) appears in a region where the SOC exceeds 50%.
- A3: The number of inflection points is two or three. In addition, the SOC region in the events A1 and A2 described above can be narrower by limiting the detailed configuration of the positive electrode, the negative electrode, the electrolytic solution, and the like. Therefore, the conditions of the events A1, A2, and A3 may be the inflection point search information D30.

The inflection point position comparing unit 36 receives determination information D31 of the battery state from the battery information server 14 via the communication unit 12. Here, the determination information D31 will be described. First, in the following description, SOH (State of Health) is used as an index indicating the degree of deterioration of the battery 10. The SOH is defined as a ratio of a full charge capacity (Ah) at the time of deterioration when an initial full charge capacity (Ah) is set to 100%. As the deterioration progresses, the SOH decreases. Furthermore, one or a plurality of inflection points defined in the inflection point search information D30 is referred to as "target inflection point".

The position of the target inflection point moves from the initial position as the battery 10 deteriorates. The determination information D31 is information in which the degradation degree of the battery, that is, the SOH is associated with the movement amount of each target inflection point from the initial position. That is, when the movement amount of the target inflection point is determined, the SOH of the battery 10 can be estimated based on the determination information D31. The estimated SOH is stored in the battery operation history storage 16 via the communication unit 12 as battery state information D32.

Meanwhile, for example, an RFID tag, a barcode, or the like (not illustrated) is provided on the housing surface of the battery 10, and presents tag identification information D41 (identification information). The identification information acquiring unit 42 in the state diagnosis device 11 reads the tag identification information D41 from the RFID tag or the like (not illustrated). The identification information acquiring unit 42 converts the tag identification information D41 into battery identification information D43 (identification information) that identifies a manufacturing number or a management number of the battery 10. The database 15 in the battery information server 14 searches for the use material, specification, characteristic data, and the like of the battery 10 based on the battery identification information D43, and provides the inflection point search information D30 suitable for life diagnosis of the battery 10 to the state diagnosis device 11.

However, in a case where the RFID tag or the like (not illustrated) is damaged or in a case where the RFID tag or the like is not originally provided, the tag identification information D41 and the battery identification information D43 cannot be obtained. The operation of the waveform parameter searching unit 44 in such a case will be described later. Although details will be described later, the battery state estimating unit 30 creates an inflection point table D71, an ID/determination information table D72, and a battery specification information table D74.

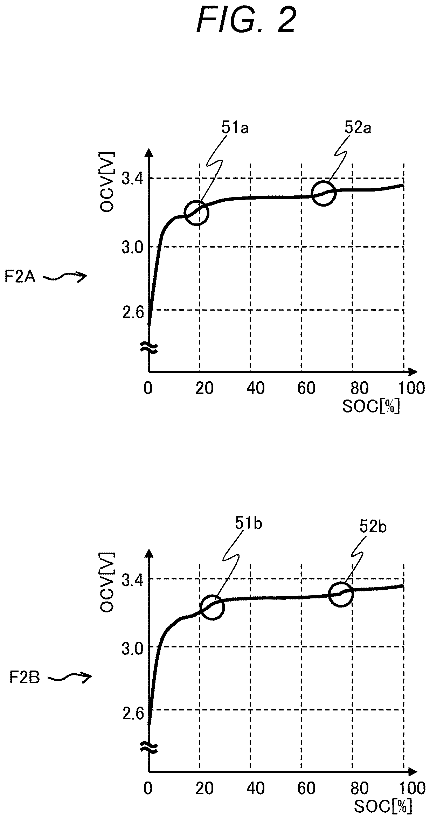

FIG. 2 is a diagram illustrating an example of a change in the OCV curve with respect to a change in the SOC.

In both the characteristics F2A and F2B of FIG. 2, the horizontal axis is the SOC and the vertical axis is the OCV.

The characteristic F2A is an example of an OCV curve in a state where the SOC is 100%, that is, in a state similar to a brand-new state. The characteristic F2B is an example of an OCV curve in a state where the deterioration progresses and the SOH becomes 80%. In the characteristic F2A, a low SOC-side inflection point 51a (feature point) appears in a region where the SOC is less than 50%, and a high SOC-side inflection point 52a (feature point) appears in a region where the SOC exceeds 50%. In the characteristic F2B, a low SOC-side inflection point 51b (feature point) and a high SOC-side inflection point 52b (feature point) appear. Here, the inflection point searched in the present embodiment is a portion where the OCV increases with respect to the increase in the SOC and the differential value of the increase rate changes from positive to negative.

When the low SOC-side inflection points 51a and 51b of the characteristics F2A and F2B are compared with each other, it can be seen that the low SOC-side inflection point 51b in the deteriorated state moves rightward (in the direction in which the SOC increases) from the low SOC-side inflection point 51a in the non-deteriorated state. The same applies to the high SOC-side inflection points 52a and 52b, and the high SOC-side inflection point 52b in the deteriorated state moves rightward from the high SOC-side inflection point 52a in the non-deteriorated state. As described above, since the movement amount of the inflection point corresponds to the change in the SOH, the SOH can be diagnosed from the movement amount of the inflection point as described above.

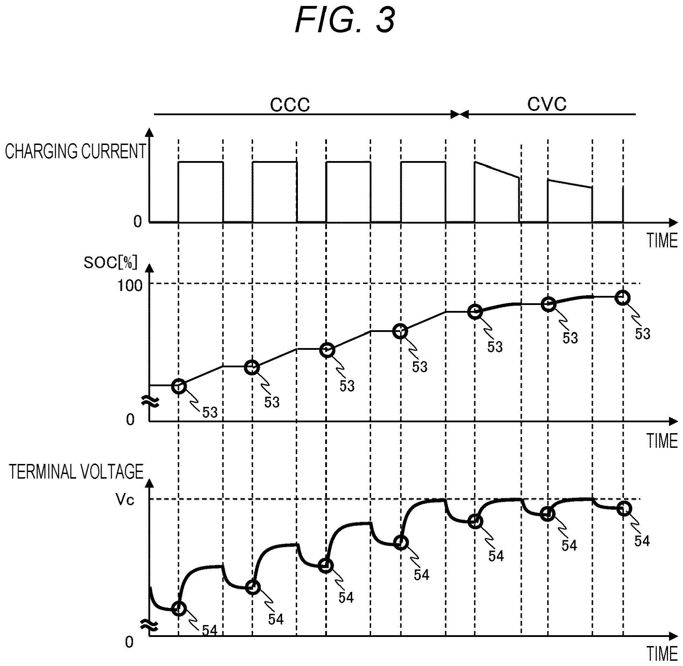

FIG. 3 is a schematic graph of a charging current, an SOC, and a terminal voltage of the battery 10 with time.

The charging current and the terminal voltage in FIG. 3 are a part of the sensor information D21 (see FIG. 1). In addition, the data processing unit 22 acquires the SOC by integrating the charging current.

In the example of FIG. 2, an example in which intermittent charging that repeats charging and pausing is employed is illustrated for simplification of description. The charging control unit 78 illustrated in FIG. 1 causes the charger 17 to execute constant current charging (CCC) in a case where the SOC is lower than a predetermined value, and constant voltage charging (CVC) in a case where the SOC is equal to or higher than the predetermined value. In the CVC, the charging control unit 78 (see FIG. 1) controls the charger 17 so that the terminal voltage of the battery 10 when supplying the charging current becomes a predetermined voltage Vc.

In FIG. 3, since a polarization phenomenon occurs in the battery 10 during a period in which the charging current is a positive value or a period immediately after the charging current is stopped, the terminal voltage of the battery 10 becomes higher than the OCV. On the other hand, when a certain time elapses after the charging current is stopped, the battery 10 enters an electrochemical reaction equilibrium state. Therefore, in the illustrated example, the terminal voltage immediately before the charging current rises from 0 to a positive value is regarded as the OCV and measured. That is, the data string of the SOC data 53 and the data string of the OCV data 54 shown in FIG. 3 are included in the battery state quantity D23 (see FIG. 1).

As described above, the waveform approximation model processing unit 24 (see FIG. 3) uses the battery state quantity D23 and the waveform approximation model information D28 to create the characteristic curve information D25 such as the characteristic curve of the OCV with respect to the SOC.

Although FIG. 3 illustrates an example in which intermittent charging is applied, the characteristic curve information D25 can be acquired by another method. For example, in an electric vehicle, an SOC is calculated by integrating a current during traveling, and a similar OCV curve is obtained by measuring a terminal voltage when the vehicle is stopped. A method based on identification of a physical model may be applied to the creation of the OCV curve. However, in the present embodiment, the method of acquiring the characteristic curve information D25 using the waveform approximation model information D28 (see FIG. 1) based on the waveform approximation model described above is adopted.

As described above, the waveform approximation model information D28 is realized by a model that expresses a waveform by an approximation formula. In this method, the characteristic of the object (battery 10) can be directly derived from the data regardless of the physical characteristic. For this reason, in recent years, batteries having new characteristics are developed one after another, it does not take time to derive the physical model, and as a result, there is an advantage that the new battery 10 can be reflected in the database 15 at an early stage. There are various implementation methods for the waveform approximation model information D28, and here, a method using Gaussian process regression (GPR) will be described. GPR is a mathematical method for generating the most probable continuous waveform from limited data.

This method is a widely known method, and thus is omitted and only the results are shown. Details of this method are described in, for example, "C.M.Bishop, Pattern Recognition and Machine Learning, Maruzen Publishing Co., Ltd. (2012)". The training data used to determine the waveform shape is defined as x and y. Here, x corresponds to the preliminary measurement result of the SOC, and y corresponds to the preliminary measurement result of the OCV. In addition, the number of pieces of training data is N. At this time, the average value of the output value $y^*$ predicted for each element of $x^*$ can be calculated by [Math. 1].

[Math. 1]

$$y - k(x, x^*)^\top [K + \lambda N I_N]^{-1} y \qquad (1)$$

In [Math. 1], $\lambda$ is a parameter for stabilizing a solution, and $I_N$ is an N×N identity matrix. k is a kernel function and is defined as, for example, the following [Math. 2].
[Math. 2]

$$k(x_n, x_m) = \theta_0 \exp\left\{-\frac{1}{2}\sum_{i=1}^{\text{Degree of input}} \eta_i(x_{ni} - x_{mi})^2\right\} + \theta_2 + \theta_3 \sum_{i=1}^{\text{Degree of input}} x_{ni}x_{mi} \qquad (2)$$

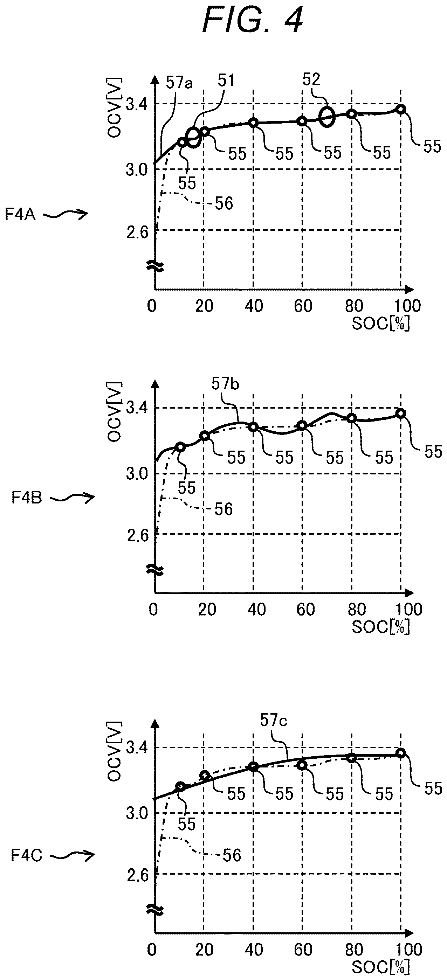

In addition, K in [Math. 1] is a matrix in which the kernel function defined by [Math. 2] is arranged for each element.
An advantage of applying GPR is that the waveform shape can be reproduced from a small number of measurement points. The OCV measurement point that can be acquired at the time of deriving the OCV curve is acquired at the timing when the charging current is 0 as illustrated in FIG. 3, and thus, conditions for allowing acquisition are limited.
Therefore, the GPR is suitable for obtaining the characteristic curve information D25, that is, the OCV waveform as accurate as possible from a small number of measurement points. In addition, since the GPR suppresses white noise in the calculation process, there is an advantage that an OCV curve can be stably acquired even when there is noise or variation at the time of measurement. Here, in [Math. 1] and [Math. 2], $\lambda$, $\eta_i$, $\theta_0$, $\theta_2$, and $\theta_3$ are parameters that can be freely determined by the user of the present method. There is also a degree of freedom in selecting training data. Therefore, the waveform approximation model processing unit 24 may derive different OCV curves depending on the waveform approximation model information D28 to be adopted. FIG. 4 illustrates an example in which different OCV curves are derived.
FIG. 4 illustrates various OCV curves possibly derived by the waveform approximation model information D28.
In the illustrated characteristics F4A, F4B, and F4C, 55 is an actual measurement point, the OCV curve 56 is a true OCV curve, and the OCV curves 57a, 57b, and 57c are derived OCV curves.
The characteristic F4A is an example in which an OCV curve suitable for deterioration diagnosis is obtained. The characteristic F4B is an example in which the OCV curve 57b fluctuates irregularly to faithfully reproduce the acquired data, and the correct low SOC-side inflection point 51 and high SOC-side inflection point 52 shown in the characteristic F4A are buried. In addition, the characteristic F4C is an example in which the smoothness of the waveform is emphasized so that the correct low SOC-side inflection point 51 and high SOC-side inflection point 52 illustrated in the characteristic F4A disappear.
Parameters such as $\lambda$, $\eta_i$, $\theta_0$, $\theta_2$, and $\theta_3$ included in the above-described [Math. 1] and [Math. 2] are collectively referred to as a waveform parameter D26. As illustrated in FIG. 4, the correct characteristic curve information D25, that is, the OCV waveform cannot be obtained depending on the setting state of the waveform parameter D26. Therefore, in the present embodiment, the waveform parameter D26 supplied from the database 15 is applied. The waveform parameter searching unit 44 determines the waveform approximation model information D28 based on the acquired waveform parameter D26 and applies the same to the waveform approximation model processing unit 24. As a result, the waveform approximation model processing unit 24 can obtain the characteristic curve information D25 such as an accurate OCV curve.

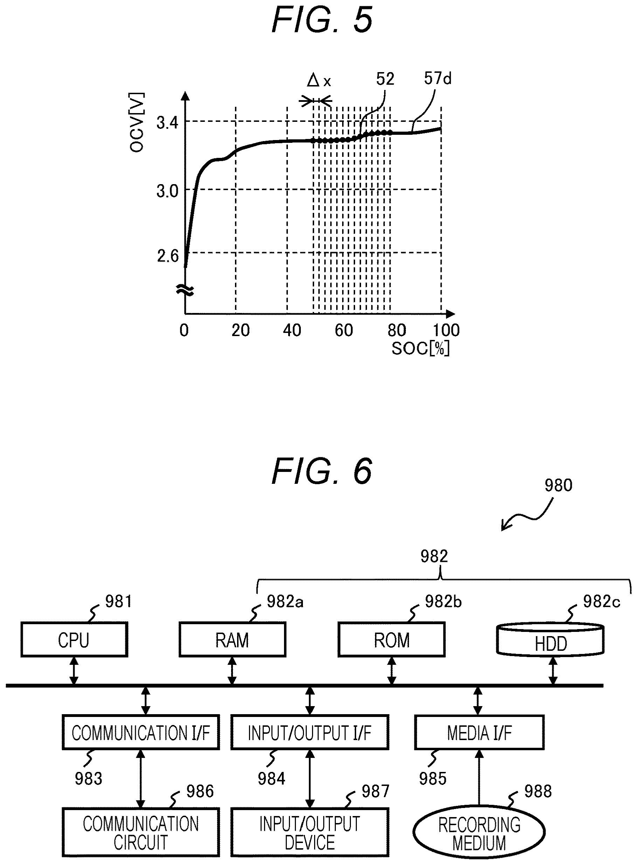

FIG. 5 is an operation explanatory diagram of the inflection point calculating unit 34.
As described above, in the present embodiment, the characteristic curve information D25 such as an OCV curve is acquired based on [Math. 1] and [Math. 2]. Therefore, it is also possible to obtain the inflection point from a point at which the result of differentiating the acquired OCV curve twice becomes 0. However, as illustrated in FIG. 5, since the OCV curve 57d is a curve with one input and one output, an inflection point can be obtained by simpler grid search. As an example, a method for obtaining the high SOC-side inflection point 52 from the OCV curve 57d will be described.
Since the range of the high SOC-side inflection point 52 is known, the SOC (=x) in the range is minutely divided by the width $\Delta x$. Then, the OCV is calculated for each divided SOC to obtain a discrete OCV value. When the i-th sample value of the discrete OCV data is $y_i$, the second differentiation can be expressed as [Math. 3], and a point at which this changes from positive to negative may be determined as an inflection point.
[Math. 3]

$$\frac{d^2 y}{dx^2} \simeq \frac{y_{i+1} + y_{i-1} - 2y_i}{\Delta x^2} \qquad (3)$$

In order not to erroneously recognize a region where the OCV hardly changes with respect to the SOC change as an inflection point, it is also preferable to set a condition that the first derivative of the OCV curve is equal to or more than a certain value. The low SOC-side inflection point (not illustrated) can also be acquired in exactly the same manner as the high SOC-side inflection point 52.

The inflection point search information D30 illustrated in FIG. 1 provides various conditions such as the existence range of the inflection point and the division width $\Delta x$ as described above to the inflection point calculating unit 34.

Although the characteristics of the iron phosphate-based lithium-ion battery have been described as an example for the state diagnosis device 11 according to the present embodiment from FIGS. 2 to 5, the present method can be applied to other batteries, for example, ternary lithium-ion batteries in exactly the same manner.

FIG. 6 is a block diagram of a computer 980.

Each of the state diagnosis device 11, the battery information server 14, and the battery operation history storage 16 illustrated in FIG. 1 includes one or a plurality of computers 980 illustrated in FIG. 6.

In FIG. 6, the computer 980 includes a CPU981, a storage unit 982, a communication interface (I/F) 983, an input/output I/F 984, and a media I/F 985. Here, the storage unit 982 includes a RAM 982a, a ROM 982b, and an HDD 982c. The communication I/F 983 is connected to a communication circuit 986. The input/output I/F 984 is connected to an input/output device 987. The media I/F 985 reads and writes data from and in a recording medium 988. The ROM 982b stores a control program executed by the CPU, various data, and the like. The CPU 981 implements various functions by executing the application program read into the RAM 982a. The inside of the state diagnosis device 11 and the battery information server 14 illustrated in FIG. 1 illustrates functions implemented by an application program or the like as blocks.

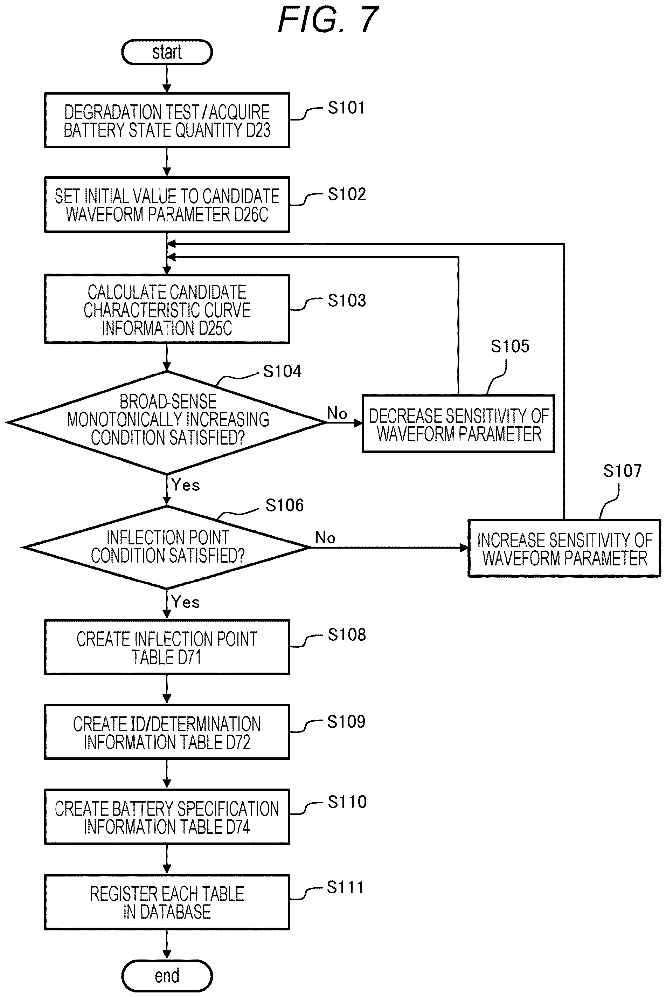

FIG. 7 is a flowchart of a database creation routine.

When the processing proceeds to step S101 in FIG. 7, the charging control unit 78 (see FIG. 1) controls the charger 17 to execute a degradation test on a specific battery 10. As a result, for the battery 10, the data processing unit 22 (see FIG. 1) acquires the sensor information D21, and acquires the battery state quantity D23 (that is, SOC, OCV, etc.) having the number of samples that enables waveform approximation. Note that the temperature of the battery 10 is also an important factor that determines the battery characteristics, and the sensor information D21 includes the temperature, but the description regarding the temperature is omitted here for simplicity of description.

In the next steps S102 to S104, the waveform parameter searching unit 44 determines a waveform parameter D26 that can create a suitable OCV curve for the data obtained in step S101. In the following description, a waveform parameter that is a provisional candidate until the waveform parameter D26 is determined is referred to as a "candidate waveform parameter D26C". Similarly, the waveform approximation model information determined based on the candidate waveform parameter D26C is referred to as candidate waveform approximation model information D28C. Similarly, the characteristic curve information D25 obtained by the candidate waveform approximation model information D28C is referred to as candidate characteristic curve information D25C. Note that, in FIG. 1, for the illustrated reference numerals (for example, "D25"), reference numerals to which one alphabet character is added (for example, "D25C") are not illustrated.

In step S102 of FIG. 7, the waveform parameter searching unit 44 sets an initial value of the candidate waveform parameter D26C. The initial value is the candidate waveform parameter D26C. Next, when the processing proceeds to step S103, the waveform parameter searching unit 44 applies the candidate waveform approximation model information D28C to the waveform approximation model processing unit 24 based on the candidate waveform parameter D26C. As a result, the waveform approximation model processing unit 24 calculates the candidate characteristic curve information D25C including the provisional OCV curve based on the battery state quantity D23 and the candidate waveform approximation model information D28C.

Next, when the processing proceeds to step S104, the waveform parameter searching unit 44 determines whether or not the OCV curve in the candidate characteristic curve information D25C satisfies a broad-sense monotonically increasing condition. Here, the broad-sense monotonically increasing condition is defined as that $f(x1) \leq f(x2)$ is satisfied when $x1 < x2$ where the SOC is a variable x and the OCV is $f(x)$.

When it is determined as "No" in step S104, the processing proceeds to step S105. Since the battery 10 has a physical property that "the OCV does not decrease even though the SOC increases", this property is used as one of the determination conditions in step S104. If this determination condition is not satisfied, for example, as illustrated in the characteristic F4B of FIG. 4, it is considered that the candidate characteristic curve information D25C (OCV curve) reacts sensitively to the acquired data and the curve fluctuates irregularly.

Therefore, in processing S105, the waveform parameter searching unit 44 decreases the sensitivity of the candidate waveform parameter D26C. Here, "decreasing the sensitivity" means adjusting the candidate waveform parameter D26C so that the OCV curve becomes smoother. For example, when the kernel function of [Math. 2] is used, $\eta_i$ may be reduced. Since $\eta_i$ represents the degree of influence of measurement data at a certain point on a distant point, this can smooth the OCV curve. Thereafter, the processing in steps S103 and S104 is executed again, and the waveform parameter searching unit 44 continues to decrease the sensitivity of the waveform parameter until "Yes" is determined in step S104.

When the broad-sense monotonically increasing condition is satisfied in this manner, "Yes" is determined in step S104, and then the processing proceeds to step S106. Here, the inflection point calculating unit 34 of the battery state estimating unit 30 determines whether or not the candidate inflection point information D34C of the candidate characteristic curve information D25C satisfies the "inflection point condition". Here, the candidate inflection point information D34C is information indicating positions (SOC values) of one or a plurality of inflection points in the candidate characteristic curve information D25C. Further, the "inflection point condition" is "whether or not the number of inflection points included in the candidate inflection point information D34C is a predetermined number or more".

When the material of the battery 10 is determined, it is considered that the number and the rough positions of inflection points fall within a predetermined range, so that this feature can be used for determining the validity of the waveform approximation model. When the number of inflection points of the OCV curve is too large, the OCV curve can be used as a waveform approximation model due to the limitation of the SOC range, and thus, a problem is that the number of inflection points is too small, for example, as in the characteristic F4C of FIG. 4.

If the number of inflection points included in the candidate inflection point information D34C is less than the predetermined number, "No" is determined in step S106, and the processing proceeds to step S107. In this case, the inflection point calculating unit 34 increases the sensitivity of the candidate waveform parameter D26C. Here, "increasing the sensitivity" means adjusting the waveform parameter so that the OCV curve more faithfully traces the acquired data. When the kernel function of [Math. 2] is used, for example, $\theta_0$ and $\theta_3$ may be increased. Thereafter, the loop of steps S103, S104, S106, and S107 is repeated until the candidate inflection point information D34C satisfies the inflection point condition. Note that the repetitive processing in steps S103 to S107 can be automated by using a nonlinear programming method with restrictive conditions or the like.

When "Yes" is determined in both steps S104 and S106, the processing proceeds to step S108. At this time point, the battery state estimating unit 30 identifies the current candidate waveform parameter D26C as the waveform parameter D26 for the battery 10, and creates the inflection point search information D30 based on the current candidate inflection point information D34C. Then, the battery state estimating unit 30 creates an inflection point table D71 in which the tag identification information D41 of the battery 10, the waveform parameter D26, and the inflection point search information D30 are associated with each other.

Next, when the processing proceeds to step S109, the battery state estimating unit 30 creates an ID/determination information table D72 in which the tag identification information D41 of the battery 10, the battery identification information D43, and the determination information D31 are associated with each other.

Next, when the processing proceeds to step S110, the battery state estimating unit 30 creates the battery specification information table D74. Here, the battery specification information table D74 is a table in which specifications (hereinafter, referred to as main specification) of the battery 10 that greatly affect battery characteristics, such as a positive electrode material, a negative electrode material, a battery capacity, and the number of cell connections, are associated with tag identification information D41 of the battery 10. The number of cell connections is the number of battery cells connected in series, the number of battery cells connected in parallel, or the like in the multi-cell module.

Next, when the processing proceeds to step S111, the battery state estimating unit 30 transmits each of the inflection point table D71, the ID/determination information table D72, and the battery specification information table D74 to the battery information server 14 via the communication unit 12. As a result, the battery information server 14 records the inflection point table D71, the ID/determination information table D72, and the battery specification information table D74 in the database 15.

In the present embodiment, when the battery identification information D43 is obtained, the waveform parameter D26 can be acquired from the battery information server 14 based on the battery identification information D43, and thus the battery specification information table D74 is not necessarily required. However, since it is conceivable that the battery identification information D43 is not set or the battery identification information D43 cannot be obtained, the battery specification information table D74 may be used in such a case. The behavior of the state diagnosis device 11 when the battery identification information D43 cannot be obtained will be described later.

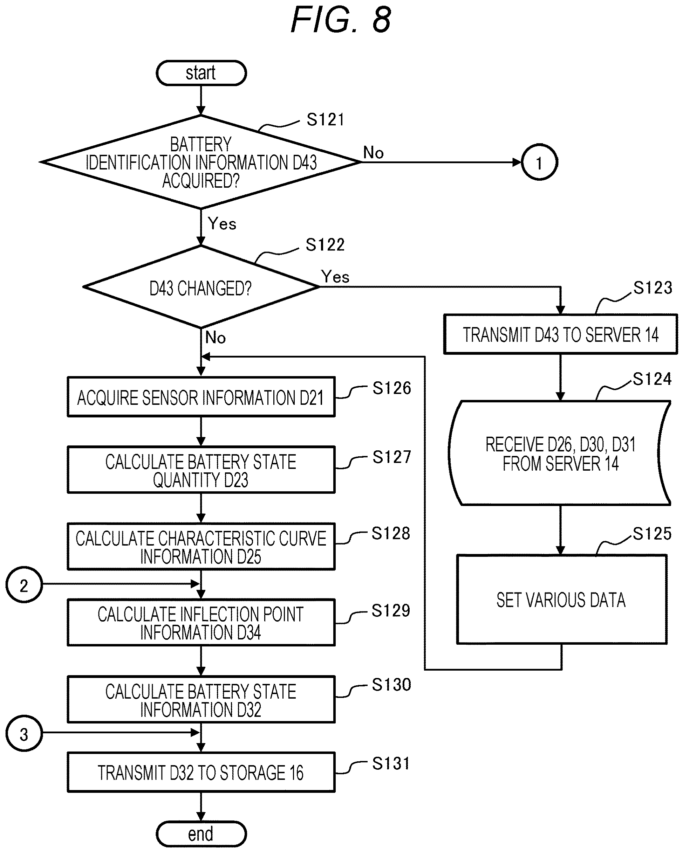

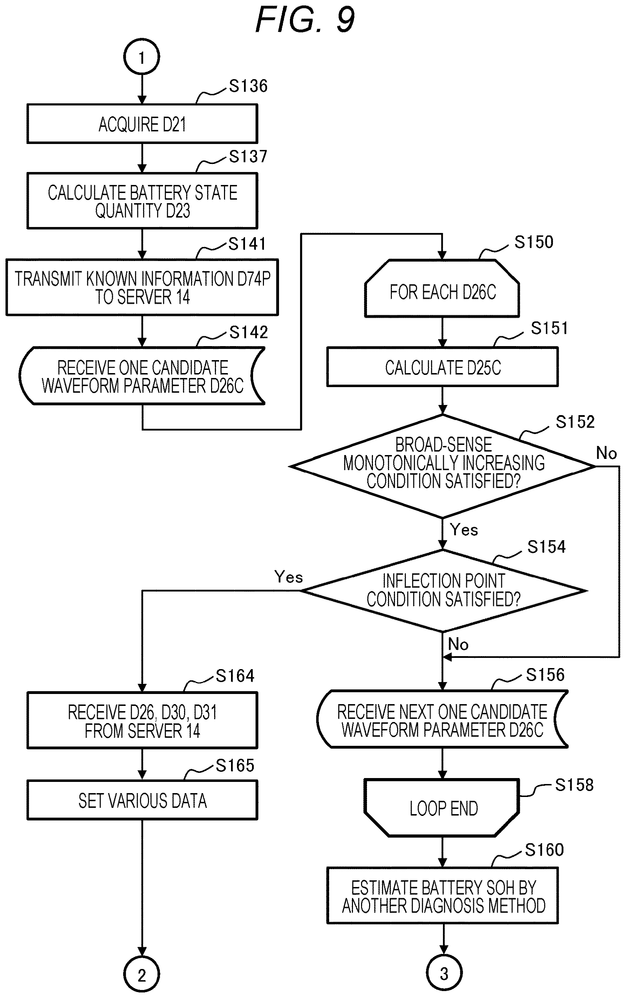

FIGS. 8 and 9 are flowcharts of a state estimation routine.

When the processing proceeds to step S121 in FIG. 8, the identification information acquiring unit 42 determines whether or not the battery identification information D43 has been acquired. Here, when "Yes" is determined here, the processing proceeds to step S122.

In step S122, the identification information acquiring unit 42 determines whether or not the battery identification information D43 has been changed. For example, when the user replaces the battery 10, the battery identification information D43 acquired this time is different from the previous one. In this case, "Yes" is determined in step S122. When "Yes" is determined in step S122, the processing proceeds to step S123.

In step S123, the identification information acquiring unit 42 transmits the battery identification information D43 to the battery information server 14 via the communication unit 12. As a result, the battery information server 14 searches the waveform parameter D26, the inflection point search information D30, and the determination information D31 corresponding to the supplied battery identification information D43, and transmits these pieces of information to the state diagnosis device 11. Next, when the processing proceeds to step S124, the state diagnosis device 11 acquires the supplied waveform parameter D26, inflection point search information D30, and determination information D31.

Next, when the processing proceeds to step S125, the battery state estimating unit 30 and the waveform parameter searching unit 44 perform various data settings of the state diagnosis device 11 based on the information acquired in step S124. That is, the waveform parameter searching unit 44 sets the state of the waveform approximation model information D28 based on the waveform parameter D26. In addition, the battery state estimating unit 30 sets the states of the inflection point calculating unit 34 and the inflection point position comparing unit 36 based on the inflection point search information D30 and the determination information D31.

When the processing in step S125 ends, the processing proceeds to step S126. In addition, also in a case where "No" is determined in step S122 described above, the processing proceeds to step S126. In step S126, the data processing unit 22 acquires the sensor information D21. Next, when the processing proceeds to step S127, the data processing unit 22 calculates a discrete battery state quantity D23 based on the sensor information D21.

Next, when the processing proceeds to step S128, the waveform approximation model processing unit 24 calculates the characteristic curve information D25 based on the waveform approximation model information D28 and the battery state quantity D23. Next, when the processing proceeds to step S129, the inflection point calculating unit 34 calculates the inflection point information D34 based on the characteristic curve information D25.

Next, when the processing proceeds to step S130, the inflection point position comparing unit 36 calculates the battery state information D32 including the SOH based on the inflection point information D34. Next, when the processing proceeds to step S131, the communication unit 12 transmits the battery state information D32 including the SOH to the battery operation history storage 16, and the processing of this routine ends.

On the other hand, when "No" is determined in step S121 described above, that is, when the identification information acquiring unit 42 cannot acquire the battery identification information D43, the processing proceeds to step S136 in FIG. 9. In step S136 of FIG. 9, the data processing unit 22 acquires the sensor information D21 as in step S126 (see FIG. 8) described above. Next, when the processing proceeds to step S137, the data processing unit 22 calculates the discrete battery state quantity D23 based on the sensor information D21, similarly to step S127 (see FIG. 8) described above.

Next, when the processing proceeds to step S141, the battery state estimating unit 30 transmits known information D74P related to the battery 10 to the battery information server 14. Here, the known information D74P refers to the content already grasped by the state diagnosis device 11 among the information that can be included in the battery specification information table D74 described above.

Upon receiving the known information D74P via the communication network 13, the battery information server 14 searches the database 15 for one candidate waveform parameter in order to create the suitable waveform approximation model information D28 estimated for the battery 10 based on the known information D74P. For example, when the capacity of the battery 10 is known and included in the known information D74P, the battery information server 14 searches for the candidate waveform parameter D26C by searching with the capacity of the battery 10 as a key.

As a result, the number of candidates of the waveform parameter D26 can be reduced and the search time can be reduced as compared with the case where the capacity is unknown. When the positive electrode material and the negative electrode material are known, the candidates can be further greatly narrowed down. The candidate of the waveform parameter D26 searched by the battery information server 14 is referred to as a candidate waveform parameter D26 C. Then, the battery information server 14 transmits the searched one candidate waveform parameter D26C to the state diagnosis device 11.

When the battery information server 14 transmits one candidate waveform parameter D26C, the processing proceeds to step S142 in the state diagnosis device 11, and the waveform parameter searching unit 44 receives the candidate waveform parameter D26C. Thereafter, the state diagnosis device 11 exits the loop in step S154 or repeats the loop of steps S150 to S158 until reception of all the candidate waveform parameters D26C is completed.

First, in step S151, the waveform parameter searching unit 44 causes the waveform approximation model processing unit 24 to create the candidate waveform approximation model information D28C based on the candidate waveform parameter D26C. As a result, the waveform approximation model processing unit 24 calculates the candidate characteristic curve information D25C based on the battery state quantity D23 and the candidate waveform approximation model information D28C.

Next, when the processing proceeds to step S152, similarly to the processing of step S104 described above, the waveform parameter searching unit 44 determines whether or not the OCV curve in the candidate characteristic curve information D25C satisfies the broad-sense monotonically increasing condition.

When "Yes" is determined here, the processing proceeds to step S154. Here, similarly to the processing of step S106 described above, the inflection point calculating unit 34 of the battery state estimating unit 30 determines whether or not the candidate inflection point information D34C indicating the inflection point of the candidate characteristic curve information D25C satisfies the inflection point condition.

When "No" is determined in any of steps S152 and S154, the processing proceeds to step S156. Here, the waveform parameter searching unit 44 receives the next new candidate waveform parameter D26C from the battery information server 14. When the new candidate waveform parameter D26C is received, the waveform parameter searching unit 44 repeats the processing in and after step S151.

On the other hand, in step S156, in a case where the new candidate waveform parameter D26C cannot be received, that is, in a case where the search for all the candidate waveform parameters D26C stored in the database 15 ends without obtaining the appropriate candidate waveform parameter D26C, the processing proceeds to step S160.

In step S160, the battery state estimating unit 30 estimates the SOH of the battery 10 by another diagnosis method. For example, since it is known that the SOH is approximately proportional to the square root of the elapsed time from the start of use, the SOH can be estimated by this. In addition, the SOH can also be estimated by counting the number of charging times in the past. In step S160, the SOH may be estimated by such a simple method.

When the battery state estimating unit 30 estimates the SOH in step S160, the processing proceeds to step S131 (see FIG. 8). Here, as described above, the communication unit 12 transmits the SOH, that is, the battery state information D32 to the battery operation history storage 16, and the processing of this routine ends.

When the candidate characteristic curve information D25C satisfies both the broad-sense monotonically increasing condition and the inflection point condition, "Yes" is determined in both steps S152 and S154, and the processing proceeds to step S164. In step S164, similarly to step S124 described above, the state diagnosis device 11 acquires (receives) the supplied waveform parameter D26, inflection point search information D30, and determination information D31.

Next, when the processing proceeds to step S165, the battery state estimating unit 30 and the waveform parameter searching unit 44 perform various data settings of the state diagnosis device 11 based on the information acquired in step S164, similarly to the processing in step S125 described above. That is, the waveform parameter searching unit 44 sets the state of the waveform approximation model information D28 based on the waveform parameter D26. In addition, the battery state estimating unit 30 sets the states of the inflection point calculating unit 34 and the inflection point position comparing unit 36 based on the inflection point search information D30 and the determination information D31. Then, steps S129,S130, and S131 described above are executed, and the processing of this routine ends.

[Second Embodiment]

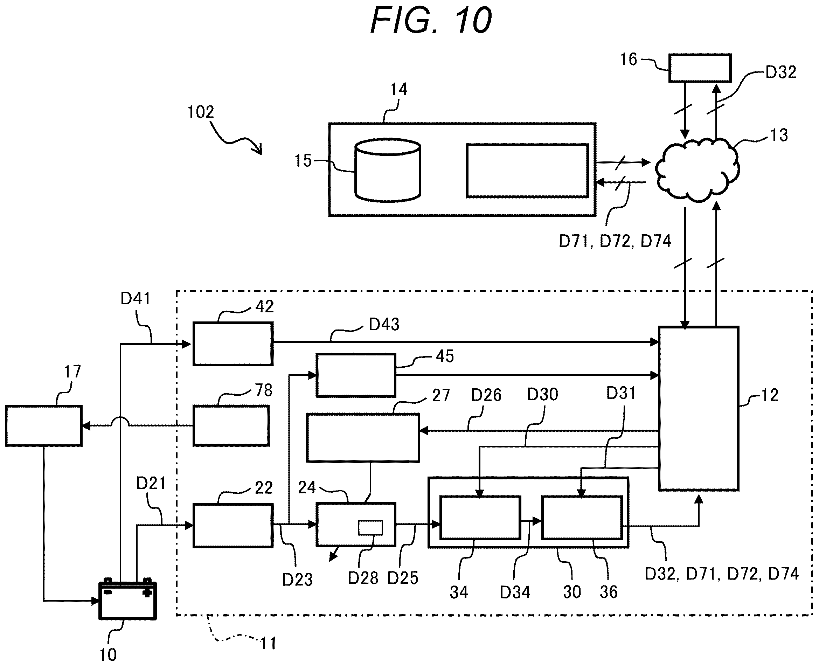

FIG. 10 is a block diagram of a state diagnosis system 102 according to the second embodiment. In the following description, portions corresponding to the respective portions of the first embodiment described above are denoted by the same reference numerals, and the description thereof may be omitted.

In the state diagnosis system 102 of the present embodiment, the waveform parameter searching unit 44 is provided inside the battery information server 14. However, among the components of the waveform parameter searching unit 44, the battery state diagnosis device 27 remains in the state diagnosis device 11. In addition, the state diagnosis device 11 is provided with a data holding unit 45.

The data holding unit 45 holds the battery state quantity D23 output from the data processing unit 22. Further, the data holding unit 45 supplies the battery state quantity D23 to the waveform parameter searching unit 44 in the battery information server 14 via the communication unit 12 and the communication network 13. The configuration and operation of the present embodiment other than those described above are similar to those of the first embodiment (see FIG. 1).

It is conceivable that the state diagnosis device 11 is realized by, for example, an in-vehicle microcomputer provided in a vehicle (not illustrated). However, there may be a case where the in-vehicle microcomputer cannot obtain sufficient processing capability for realizing the waveform parameter searching unit 44. In such a case, as in the present embodiment, it is preferable to provide the waveform parameter searching unit 44 in the battery information server 14 provided outside the vehicle. As a result, it is possible to search for the optimal waveform parameter D26 in a shorter time using the battery information server 14 generally having a high calculation capability.

However, in the present embodiment, it is necessary that communication between the state diagnosis device 11 and the battery information server 14 is always established when performing the battery state diagnosis. Therefore, for example, the present embodiment is preferably adopted in a case where the state diagnosis device 11 is provided in a charger facility (not illustrated). The charger is often a stationary facility, and in this case, a communication path can be established by wire, so that the reliability of communication can be improved as compared with the case of using radio.

[Third Embodiment]

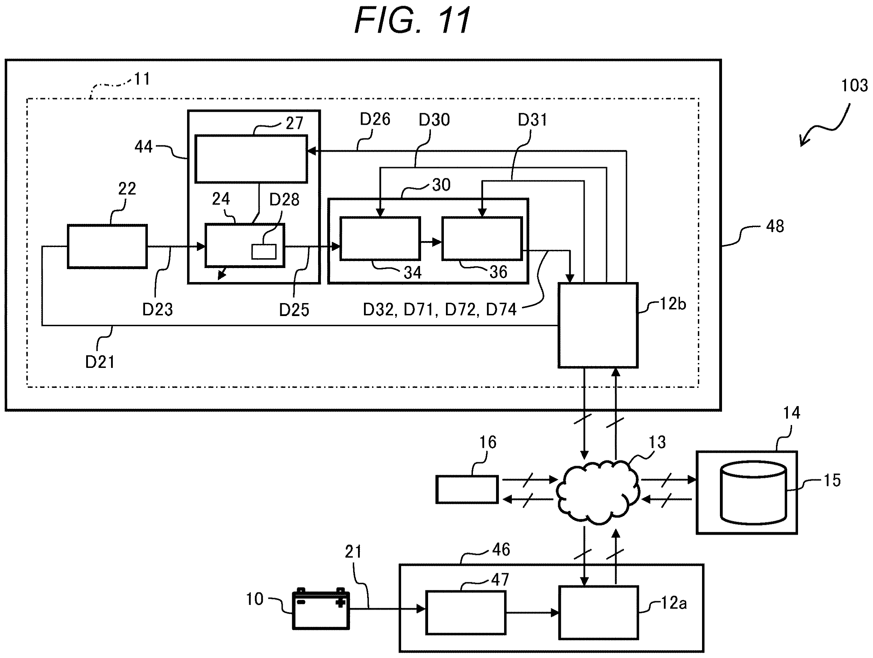

FIG. 11 is a block diagram of a state diagnosis system 103 according to a third embodiment. Note that, in the following description, portions corresponding to the respective portions of the above-described other embodiments are denoted by the same reference numerals, and the description thereof may be omitted.

In the configuration illustrated in FIG. 1, it is preferable to dispose the state diagnosis device 11 in a place where battery information can be directly handled, such as on a vehicle or in the vicinity of the charger 17. On the other hand, in FIG. 11, the function of the state diagnosis device 11 can be used by an application program via a network.

In FIG. 11, the state diagnosis system 103 includes a data logger 46, a battery operation history storage 16, a battery information server 14, and a data logger 46. In addition, the application server device 48 includes a state diagnosis device 11. The state diagnosis device 11 according to the present embodiment includes a data processing unit 22, a waveform parameter searching unit 44, a battery state estimating unit 30, and a communication unit 12b.

The data logger 46 includes a communication unit 12a and a data acquisition unit 47. The data acquisition unit 47 sequentially or collectively transmits the sensor information of the battery 10 to the battery information server 14 via the communication unit 12a.

The application server device 48 receives the sensor information D21 using the communication unit 12b on the application server device side. In addition, the application server device 48 acquires the information of the database 15 from the battery information server 14 using the communication unit 12b on the application server device side. On the basis of the received sensor information D21, the application server device 48 calculates battery state information D32 such as an SOH of the battery 10 by processing similar to that of the first embodiment (See FIGS. 8 and 9).

The calculated battery state information D32 is sent to the battery operation history storage 16 via the communication unit 12b, and is used for battery-related services such as replacement notification service of the battery 10 and battery price determination. According to the present embodiment, it is preferable when there are a large number of application server devices 48 that provide the battery diagnosis service on the communication network 13.

In general, since the number of batteries to be diagnosed is very large, the load on the application server device 48 increases when the number of the application server devices 48 is small. However, the battery diagnosis service is expected to become widespread in the future, and many application server devices 48 are expected to be provided. In this case, since the number of batteries to be diagnosed per one application server device 48 is reduced, the load of the high-performance application server device 48 is reduced, and sufficient performance can be obtained. In this case, there is an advantage that it is easy to cope with version upgrade and the like as compared with a case where the state diagnosis device 11 is mounted as an in-vehicle device.

[Fourth Embodiment]

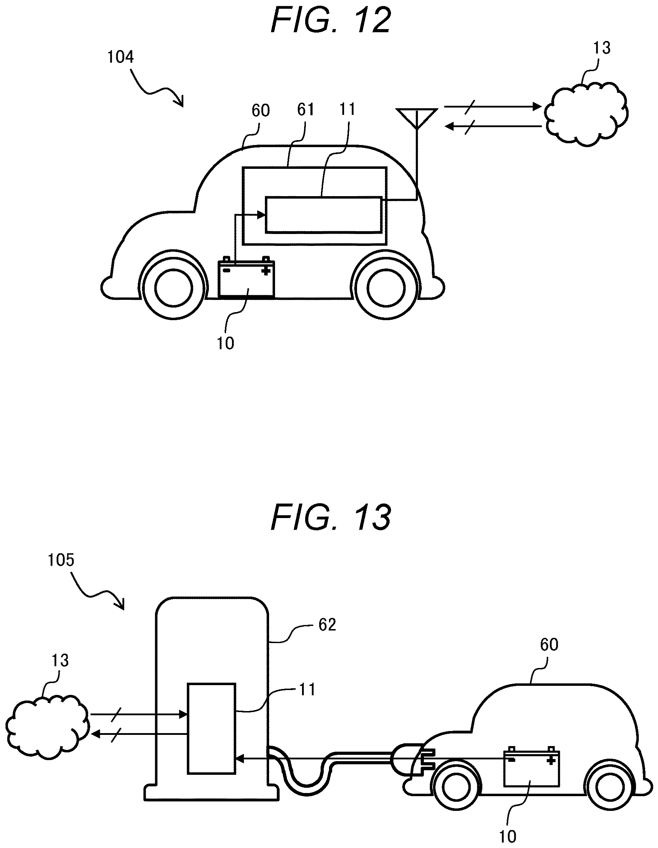

FIG. 12 is a block diagram of a state diagnosis system 104 according to a fourth embodiment. Note that, in the following description, portions corresponding to the respective portions of the above-described other embodiments are denoted by the same reference numerals, and the description thereof may be omitted.

In FIG. 12, an electric vehicle 60 (vehicle) includes a battery 10 and a battery management system (BMS) 61. The BMS61 includes a state diagnosis device 11.

In the present implementation, even when communication via the communication network 13 cannot be performed in the electric vehicle 60, the state diagnosis device 11 can always acquire the operating state of the battery 10. If the waveform parameter or the like can be updated once at the time of battery replacement, there is an effect that the state can be constantly estimated even when the vehicle is traveling in an area with a poor radio wave condition. In addition, since the battery management system 61 is already equipped with current and voltage sensors for that purpose, there is an advantage that the state diagnosis device 11 can be realized at low cost.

[Fifth Embodiment]

FIG. 13 is a block diagram of a state diagnosis system 105 according to a fifth embodiment. Note that, in the following description, portions corresponding to the respective portions of the above-described other embodiments are denoted by the same reference numerals, and the description thereof may be omitted.

In FIG. 13, the electric vehicle 60 includes a battery 10, and a charger 62 includes a state diagnosis device 11. In general, since the charger 62 is operated stationary, there is a margin in terms of weight, and a high-performance microcomputer can be used for the state diagnosis device 11. In addition, it is also possible to connect to the communication network 13 by wire, and the communication quality is stable. As a result, there is an effect that the state of the battery 10 can be estimated at high speed. In addition, there is an effect that the present invention can be applied to an application in which a charging method is changed using the estimated deterioration state of the battery.

[Effects of Embodiment]

As described above, according to the above-described embodiment, the state diagnosis device (11) includes: the waveform approximation model processing unit (24) that acquires characteristic curve information (D25) based on a state quantity (D21) of a battery (10) to be measured and waveform approximation model information (D28) for deriving the characteristic curve information (D25) of the battery (10) from the state quantity (D21); the battery state estimating unit (30) that estimates a state of the battery (10) based on positions of feature points (51a,51b,52a,52b) satisfying a predetermined condition in the characteristic curve information (D25); and the waveform parameter searching unit (44) that selects, from a database (15) that stores a plurality of waveform parameters (D26) for determining a waveform shape of the characteristic curve information (D25) according to each type corresponding to a plurality of types of the batteries (10), the waveform parameter (D26) corresponding to the battery (10) to be measured, and applies the selected waveform parameter (D26) to the waveform approximation model information (D28). As a result, the waveform parameter (D26) corresponding to the battery (10) to be measured can be selected and applied to the waveform approximation model information (D28), so that the state of the battery (10) can be appropriately determined.

Further, the characteristic curve information (D25) is a characteristic of the terminal open voltage (OCV) with respect to the charging rate (SOC) of the battery (10), and the battery state estimating unit (30) more preferably sets the candidate waveform parameter (D26C) to the waveform parameter (D26) on condition that the candidate characteristic curve information (D25C) calculated based on the candidate waveform parameter (D26C) that is a candidate value of the waveform parameter (D26) satisfies a broad-sense monotonically increasing condition. As a result, an appropriate candidate waveform parameter (D26C) can be set as the waveform parameter (D26).

Further, the feature point (51a, 51b, 52a, 52b) is an inflection point that occurs in the characteristic curve information (D25), and it is more preferable that the battery state estimating unit (30) set the candidate waveform parameter (D26C) to the waveform parameter (D26) on a further condition that the characteristic curve information (D25) satisfies a predetermined inflection point condition. As a result, a more appropriate candidate waveform parameter (D26C) can be set as the waveform parameter (D26).

Further, the inflection point condition is more preferably a condition that one feature point (51a, 52a) appears in a region where the charging rate (SOC) is less than 50% in the candidate characteristic curve information (D25C), another feature point (51b, 52b) appears in a region where the charging rate (SOC) exceeds 50% in the candidate characteristic curve information (D25C), and the number of all feature points (51a, 51b, 52a, 52b) is "2" or "3". As a result, particularly when the battery (10) is a lithiumion battery, a more appropriate candidate waveform parameter (D26C) can be set as the waveform parameter (D26).

According to another aspect, the above embodiment is a state diagnosis system (101) that determines a state of a battery (10), the state diagnosis system (101) including: a state diagnosis device (11) that estimates a state of the battery (10) based on a state quantity (D21) of the battery (10); and a server device (14) that transmits and receives data to and from the state diagnosis device (11) via a communication network (13), in which the server device (14) includes a database (15) that stores identification information (D41,D43) or the state quantity (D21) for identifying the battery (10) and a waveform parameter (D26) for determining a waveform shape of characteristic curve information (D25) of the battery (10) in association with each other, and the state diagnosis system further including: a waveform approximation model processing unit (24) that acquires the characteristic curve information (D25) of the battery (10) based on waveform approximation model information (D28) and the state quantity (D21); a battery state estimating unit (30) that estimates a state of the battery (10) based on a position of a feature point (51a,51b,52a,52b) satisfying a predetermined condition in the characteristic curve information (D25); and a waveform parameter searching unit (44) that reads the waveform parameter (D26) for determining a waveform shape of the characteristic curve information (D25) from the database (15). As a result, even in this configuration, the waveform parameter (D26) corresponding to the battery (10) to be measured can be selected and applied to the waveform approximation model information (D28), so that the state of the battery (10) can be appropriately determined.

Further, the characteristic curve information (D25) is a characteristic of the terminal open voltage (OCV) with respect to the charging rate (SOC) of the battery (10), and the battery state estimating unit (30) more preferably sets the candidate waveform parameter (D26C) to the waveform parameter (D26) on condition that the candidate characteristic curve information (D25C) calculated based on the candidate waveform parameter (D26C) that is a candidate value of the waveform parameter (D26) satisfies a broad-sense monotonically increasing condition. As a result, an appropriate candidate waveform parameter (D26C) can be set as the waveform parameter (D26).

Further, the waveform parameter searching unit (44) is more preferably provided in the server device (14) and has a function of receiving the state quantity (D21) via the communication network (13) and selecting the waveform parameter (D26) based on the broad-sense monotonically increasing condition. The search for waveform parameters usually requires a large number of trials. According to the second embodiment (see FIG. 9) described above, since the server device (14) includes the waveform parameter searching unit (44), it is possible to directly exchange the waveform parameters with respect to the database (15). As a result, overhead due to communication can be suppressed, and the processing time can be further reduced.

In addition, the waveform approximation model processing unit (24) and the battery state estimating unit (30) may be realized by a battery management system (61) mounted on the vehicle (60). In particular, when the vehicle (60) is an electric vehicle, the operating state of the battery (10) can be acquired even when the battery management system (61) cannot secure communication with the communication network (13). For example, if the waveform parameter and the like can be updated once at the time of replacement of the battery (10), there is an effect that the state can be constantly estimated even when the vehicle travels in an area with a poor radio wave condition.

In addition, the waveform approximation model processing unit (24) and the battery state estimating unit (30) may be realized by a charger (62) connected to a vehicle (60) on which the battery (10) is mounted. In general, since the charger (62) is operated stationary, there is a margin in terms of weight, and a high-performance microcomputer can be used. In addition, it is also possible to connect to the communication network (13) by wire, and the communication quality is stable. As a result, there is an effect that the state of the battery (10) can be estimated at high speed. In addition, there is an effect of being applicable to an application of changing a charging method using the estimated deterioration state of the battery.

In addition, the waveform approximation model processing unit (24) and the battery state estimating unit (30) may be implemented by a server device (14). As a result, the computer resources of the server device (14) can be effectively used, and the calculation time can be further reduced.

The state diagnosis system 103 according to the third embodiment may further include an application server device (48) connected to a communication network (13), and the waveform approximation model processing unit (24) and the battery state estimating unit (30) may be implemented by the application server device (48). In particular, by providing the plurality of application server devices (48), the battery (10) side can select the application server device (48) in the idle state at any time and cause the state estimation of the battery (10) to be performed. As a result, the waiting time for state estimation can be further reduced, and the average processing time can be shortened.

[Modified Example]

The present invention is not limited to the above-described embodiments, and various modifications are possible. The above-described embodiments have been exemplified for easy understanding of the present invention, and are not necessarily limited to those having all the described configurations. In addition, a part of the configuration of a certain embodiment can be replaced with the configuration of another embodiment, and the configuration of another embodiment can be added to the configuration of a certain embodiment. In addition, a part of the configuration of each embodiment can be deleted, or another configuration can be added or replaced. In addition, the control lines and the information lines illustrated in the drawings indicate what is considered to be necessary for the description, and do not necessarily indicate all the control lines and the information lines necessary for the product. In practice, it may be considered that almost all the configurations are connected to each other. Possible modifications to the above embodiment are, for example, as follows.

(1) Since hardware such as the state diagnosis device 11 and the battery information server 14 in the above embodiment can be realized by a general computer, the flowcharts illustrated in FIGS. 7 to 9, programs for executing various processing described above, and the like may be stored in a storage medium or distributed via a transmission path.

(2) The processing illustrated in FIGS. 7 to 9 and each processing described above are described as software processing using a program in the above embodiment, but a part or all of the processing may be replaced with hardware processing using an application specific integrated circuit (ASIC), a field programmable gate array (FPGA), or the like.

(3) In each of the above embodiments, the battery information server 14 or the like identifies the battery 10 by the tag identification information D41 or the battery identification information D43, but may identify the battery 10 by the sensor information D21.

(4) In each of the above embodiments, the feature point is an "inflection point", but a point other than the inflection point may be used as the feature point.

(5) The function of the state diagnosis device 11 can be implemented by various devices other than the example of each embodiment described above. For example, the entire function of the state diagnosis device 11 including the waveform approximation model processing unit 24, the battery state estimating unit 30, and the like may be implemented by the battery information server 14.

Reference Signs List

10 battery
11 state diagnosis device
13 communication network
14 battery information server (server device)
15 database
24 waveform approximation model processing unit
30 battery state estimating unit

44 waveform parameter searching unit
48 application server device
51a, 52a low SOC-side inflection point (feature point)
51b, 52b low SOC-side inflection point (feature point)
60 electric vehicle (vehicle)
61 battery management system
62 charger
101, 102, 103, 104, 105 state diagnosis system
D21 sensor information (state quantity)
D25 characteristic curve information
D26 waveform parameter
D28 waveform approximation model information
D41 tag identification information (identification information)
D43 battery identification information (identification information)
D25C candidate characteristic curve information
D26C candidate waveform parameter

**Claims**

1. A state diagnosis device comprising:

   a waveform approximation model processing unit that acquires characteristic curve information based on a state quantity of a battery to be measured and waveform approximation model information for deriving the characteristic curve information of the battery from the state quantity;
   a battery state estimating unit that estimates a state of the battery based on positions of feature points satisfying a predetermined condition in the characteristic curve information; and
   a waveform parameter searching unit that selects, from a database that stores a plurality of waveform parameters for determining a waveform shape of the characteristic curve information according to each type corresponding to a plurality of types of the batteries, the waveform parameter corresponding to the battery to be measured, and applies the selected waveform parameter to the waveform approximation model information.

2. The state diagnosis device according to claim 1, wherein

   the characteristic curve information is a characteristic of a terminal open voltage with respect to a charging rate of the battery, and
   the battery state estimating unit sets a candidate waveform parameter that is a candidate value of the waveform parameter to the waveform parameter on condition that candidate characteristic curve information calculated based on the candidate waveform parameter satisfies a broad-sense monotonically increasing condition.

3. The state diagnosis device according to claim 2, wherein

   the feature points are inflection points generated in the characteristic curve information, and
   the battery state estimating unit sets the candidate waveform parameter to the waveform parameter on further condition that the characteristic curve information satisfies a predetermined inflection point condition.

4. The state diagnosis device according to claim 3, wherein
   the inflection point condition is a condition that one of the feature points appears in a region where the charging rate is less than 50% in the candidate characteristic curve information, another one of the feature points appears in a region where the charging rate exceeds 50% in the candidate characteristic curve information, and the number of all the feature points is "2" or "3".

5. A state diagnosis system that determines a state of a battery, the state diagnosis system comprising:

   a state diagnosis device that estimates a state of the battery based on a state quantity of the battery; and
   a server device that transmits and receives data to and from the state diagnosis device via a communication network, wherein
   the server device includes a database that stores identification information or the state quantity for identifying the battery and a waveform parameter for determining a waveform shape of characteristic curve information of the battery in association with each other, and

the state diagnosis system further comprising:

a waveform approximation model processing unit that acquires the characteristic curve information of the battery based on waveform approximation model information and the state quantity;

a battery state estimating unit that estimates the state of the battery based on a position of a feature point satisfying a predetermined condition in the characteristic curve information; and

a waveform parameter searching unit that reads the waveform parameter for determining the waveform shape of the characteristic curve information from the database.

6. The state diagnosis system according to claim 5, wherein

the characteristic curve information is a characteristic of a terminal open voltage with respect to a charging rate of the battery, and

the battery state estimating unit sets the candidate waveform parameter to the waveform parameter on condition that candidate characteristic curve information calculated based on a candidate waveform parameter that is a candidate value of the waveform parameter satisfies a broad-sense monotonically increasing condition.

7. The state diagnosis system according to claim 5, wherein the waveform parameter searching unit is provided in the server device and has a function of receiving the state quantity via the communication network and selecting a waveform parameter based on a broad-sense monotonically increasing condition.

8. The state diagnosis system according to claim 5 or 6, wherein the waveform approximation model processing unit and the battery state estimating unit are implemented by a battery management system mounted on a vehicle.

9. The state diagnosis system according to claim 5 or 6, wherein the waveform approximation model processing unit and the battery state estimating unit are implemented by a charger connected to a vehicle mounted with a battery.

10. The state diagnosis system according to claim 5 or 6, wherein the waveform approximation model processing unit and the battery state estimating unit are implemented by the server device.

11. The state diagnosis system according to claim 5, further comprising an application server device connected to the communication network, wherein

the waveform approximation model processing unit and the battery state estimating unit are implemented by the application server device.

FIG. 1

# FIG. 2

# FIG. 3

# FIG. 4

F4A →

F4B →

F4C →

## FIG. 5

## FIG. 6

## FIG. 7

```
                    ( start )
                        │
                        ▼
        ┌───────────────────────────────┐
        │ DEGRADATION TEST / ACQUIRE     │───── S101
        │ BATTERY STATE QUANTITY D23     │
        └───────────────────────────────┘
                        │
                        ▼
        ┌───────────────────────────────┐
        │ SET INITIAL VALUE TO CANDIDATE │───── S102
        │ WAVEFORM PARAMETER D26C        │
        └───────────────────────────────┘
                        │
                        ▼
        ┌───────────────────────────────┐
        │ CALCULATE CANDIDATE            │───── S103
        │ CHARACTERISTIC CURVE           │
        │ INFORMATION D25C               │
        └───────────────────────────────┘
                        │
                        ▼                              S105
                 ╱ S104 ╲                    ┌──────────────────────┐
               ╱ BROAD-SENSE ╲      No       │ DECREASE SENSITIVITY OF │
              ╱ MONOTONICALLY   ╲────────────│ WAVEFORM PARAMETER     │
              ╲ INCREASING      ╱            └──────────────────────┘
               ╲ CONDITION     ╱
                 ╲ SATISFIED? ╱
                        │ Yes
                        ▼                              S107
                 ╱ S106 ╲                    ┌──────────────────────┐
               ╱ INFLECTION ╲       No       │ INCREASE SENSITIVITY OF │
              ╱  POINT        ╲─────────────→│ WAVEFORM PARAMETER     │
              ╲  CONDITION    ╱              └──────────────────────┘
               ╲ SATISFIED?  ╱
                        │ Yes
                        ▼
        ┌───────────────────────────────┐
        │ CREATE INFLECTION POINT        │───── S108
        │ TABLE D71                      │
        └───────────────────────────────┘
                        │
                        ▼
        ┌───────────────────────────────┐
        │ CREATE ID/DETERMINATION        │───── S109
        │ INFORMATION TABLE D72          │
        └───────────────────────────────┘
                        │
                        ▼
        ┌───────────────────────────────┐
        │ CREATE BATTERY SPECIFICATION   │───── S110
        │ INFORMATION TABLE D74          │
        └───────────────────────────────┘
                        │
                        ▼
        ┌───────────────────────────────┐
        │ REGISTER EACH TABLE            │───── S111
        │ IN DATABASE                    │
        └───────────────────────────────┘
                        │
                        ▼
                    ( end )
```

# FIG. 8

```
                    ( start )
                        │
                        ▼
              ╱────────────────────╲
             ╱      BATTERY          ╲  ───── S121
            ╱ IDENTIFICATION INFO D43 ╲      No
            ╲   ACQUIRED?             ╱ ──────────────────────────► (1)
             ╲                       ╱
              ╲─────────────────────╱
                        │ Yes
                        ▼
                                                       S122
              ╱────────────────────╲ ─────────┘
             ╱                      ╲     Yes                            S123
            ╱    D43 CHANGED?        ╲ ───────────────────► ┌────────────────────────────┐
            ╲                        ╱                      │ TRANSMIT D43 TO SERVER 14  │
             ╲──────────────────────╱                      └────────────────────────────┘
                        │ No                                           │
                        ▼                                              ▼         S124
       ┌──────────────────────────────┐ ─ S126           ┌──────────────────────────────┐
       │ ACQUIRE SENSOR INFORMATION D21│                 │   RECEIVE D26, D30, D31       │
       └──────────────────────────────┘                 │    FROM SERVER 14             │
                        │                                └──────────────────────────────┘
                        ▼                                              │
       ┌──────────────────────────────┐ ─ S127                        ▼         S125
       │   CALCULATE BATTERY STATE     │                 ┌──────────────────────────────┐
       │      QUANTITY D23             │                 │                              │
       └──────────────────────────────┘                 │     SET VARIOUS DATA         │
                        │                                │                              │
                        ▼                                └──────────────────────────────┘
       ┌──────────────────────────────┐ ─ S128                        │
       │ CALCULATE CHARACTERISTIC CURVE│                               │
       │     INFORMATION D25           │                               │
       └──────────────────────────────┘                               │
                        │                                              │
   (2) ─────────────────▼                                             │
       ┌──────────────────────────────┐ ─ S129                        │
       │  CALCULATE INFLECTION POINT   │                               │
       │     INFORMATION D34           │                               │
       └──────────────────────────────┘                               │
                        │                                              │
                        ▼                                              │
       ┌──────────────────────────────┐ ─ S130 ◄─────────────────────┘
       │   CALCULATE BATTERY STATE     │
       │     INFORMATION D32           │
       └──────────────────────────────┘
                        │
   (3) ─────────────────▼
       ┌──────────────────────────────┐ ─ S131
       │  TRANSMIT D32 TO STORAGE 16   │
       └──────────────────────────────┘
                        │
                        ▼
                     ( end )
```

# FIG. 9

```
        (1)
         │
         ▼
  ┌──────────────────┐  S136
  │   ACQUIRE D21    │
  └──────────────────┘
         │
         ▼
  ┌──────────────────┐  S137
  │ CALCULATE BATTERY STATE │
  │    QUANTITY D23   │
  └──────────────────┘
         │
         ▼
  ┌──────────────────────────┐  S141
  │ TRANSMIT KNOWN INFORMATION D74P │
  │      TO SERVER 14        │
  └──────────────────────────┘
         │
         ▼
  ┌──────────────────────────┐  S142
  │ RECEIVE ONE CANDIDATE    │
  │ WAVEFORM PARAMETER D26C  │
  └──────────────────────────┘
```

FOR EACH D26C — S150

CALCULATE D25C — S151

BROAD-SENSE MONOTONICALLY INCREASING CONDITION SATISFIED? — S152 — No

Yes

INFLECTION POINT CONDITION SATISFIED? — S154

Yes — No

RECEIVE D26, D30, D31 FROM SERVER 14 — S164

SET VARIOUS DATA — S165

RECEIVE NEXT ONE CANDIDATE WAVEFORM PARAMETER D26C — S156

LOOP END — S158

ESTIMATE BATTERY SOH BY ANOTHER DIAGNOSIS METHOD — S160

(2)   (3)

24

FIG. 10

FIG. 11

EP 4 492 074 A1

## FIG. 12

## FIG. 13

## INTERNATIONAL SEARCH REPORT

International application No.

**PCT/JP2023/000629**

### A. CLASSIFICATION OF SUBJECT MATTER

*G01R 31/392*(2019.01)i; *G01R 31/367*(2019.01)i; *G01R 31/382*(2019.01)i; *G01R 31/385*(2019.01)i; *H01M 10/48*(2006.01)i
FI: G01R31/392; G01R31/382; G01R31/385; G01R31/367; H01M10/48 P

According to International Patent Classification (IPC) or to both national classification and IPC

### B. FIELDS SEARCHED

Minimum documentation searched (classification system followed by classification symbols)

G01R31/392; G01R31/367; G01R31/382; G01R31/385; H01M10/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | CN 111693882 A (LI, Honghai et al.) 22 September 2020 (2020-09-22) paragraphs [0018]-[0026], fig. 1-2 | 1 |
| Y | paragraphs [0018]-[0026], fig. 1-2 | 2, 5-11 |
| Y | JP 2018-048913 A (CALSONIC KANSEI CORP) 29 March 2018 (2018-03-29) paragraphs [0001]-[0002], [0033]-[0036], fig. 3 | 2, 6-10 |
| Y | CN 110954832 A (ZHANG, Caiping et al.) 03 April 2020 (2020-04-03) paragraphs [0001], [0020]-[0021], fig. 1 | 5-11 |
| A | US 2015/0066406 A1 (SUN, Jing et al.) 05 March 2015 (2015-03-05) entire text, all drawings | 1-11 |
| A | JP 2016-012984 A (HITACHI CHEMICAL CO LTD) 21 January 2016 (2016-01-21) entire text, all drawings | 1-11 |
| A | JP 2016-508215 A (LG CHEMICAL LTD) 17 March 2016 (2016-03-17) entire text, all drawings | 1-11 |

☑ Further documents are listed in the continuation of Box C.   ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 March 2023** | **04 April 2023** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 **Japan** | |
| | Telephone No. |

Form PCT/ISA/210 (second sheet) (January 2015)

| INTERNATIONAL SEARCH REPORT | | International application No. |
|---|---|---|
| | | **PCT/JP2023/000629** |

**C. DOCUMENTS CONSIDERED TO BE RELEVANT**

| Category* | Citation of document, with indication, where appropriate, of the relevant passages | Relevant to claim No. |
|---|---|---|
| A | JP 2021-113762 A (TOYO SYSTEM CO LTD) 05 August 2021 (2021-08-05)<br>entire text, all drawings | 1-11 |

Form PCT/ISA/210 (second sheet) (January 2015)

INTERNATIONAL SEARCH REPORT
Information on patent family members

International application No.

**PCT/JP2023/000629**

| Patent document cited in search report | | | Publication date (day/month/year) | Patent family member(s) | | | Publication date (day/month/year) |
|---|---|---|---|---|---|---|---|
| CN | 111693882 | A | 22 September 2020 | (Family: none) | | | |
| JP | 2018-048913 | A | 29 March 2018 | (Family: none) | | | |
| CN | 110954832 | A | 03 April 2020 | (Family: none) | | | |
| US | 2015/0066406 | A1 | 05 March 2015 | WO entire text, all drawings | 2015/031437 | A1 | |
| JP | 2016-012984 | A | 21 January 2016 | US entire text, all drawings WO EP KR CN | 2017/0141589 2016/002485 3163710 10-2017-0008807 106663960 | A1 A1 A1 A A | |
| JP | 2016-508215 | A | 17 March 2016 | US entire text, all drawings WO EP KR CN | 2015/0226809 2014/088325 2899558 10-2014-0071936 104871021 | A1 A1 A1 A A | |
| JP | 2021-113762 | A | 05 August 2021 | EP entire text, all drawings WO KR CN | 4053962 2021/149483 10-2022-0104213 115210591 | A1 A1 A A | |

Form PCT/ISA/210 (patent family annex) (January 2015)

30

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006300561 A

**Non-patent literature cited in the description**

- **C.M.BISHOP**. Pattern Recognition and Machine Learning. Maruzen Publishing Co., Ltd., 2012